# EUROPÄISCHE PATENTSCHRIFT

(11) **EP 3 746 747 B1**
(45) Veröffentlichungstag und Bekanntmachung des Hinweises auf die Patenterteilung: **12.01.2022**
(21) Anmeldenummer: 19703064.6
(22) Anmeldetag: 01.02.2019
(51) Int. Cl.: G01D 5/24, H03K 17/96

(54) **KAPAZITIVES MESSSYSTEM**
CAPACITIVE MEASURING SYSTEM
SYSTÈME DE MESURE CAPACITIF

(30) Priorität: 03.02.2018 DE 102018000884
(43) Veröffentlichungstag der Anmeldung: 09.12.2020
(73) Patentinhaber: KOSTAL Automobil Elektrik GmbH & Co. KG, 58513 Lüdenscheid (DE)
(72) Erfinder: ZELENY, Torben, 42281 Wuppertal (DE); FREIWALD, Jan, 44149 Dortmund (DE); BORGMANN, Uwe, 45665 Recklinghausen (DE)
(74) Vertreter: Kerkmann, Detlef
(86) Internationale Anmeldenummer: PCT/EP2019/052525
(87) Internationale Veröffentlichungsnummer: WO 2019/149901

(56) Entgegenhaltungen:
- WO-A2-2009/015404
- DE-T2- 3 782 948
- DE-T5-112014 001 880

## Beschreibung

Die Erfindung betrifft ein kapazitives Messsystem, welches mehrere kapazitive Sensoren und eine Auswerteschaltung aufweist, wobei die kapazitiven Sensoren mit einem monofrequenten Spannungssignal beaufschlagt werden, wobei die Ausgangssignale der kapazitiven Sensoren über einen mehrkanaligen analogen Multiplexer alternierend mit einem Synchrongleichrichter verbunden werden, und wobei die Signalverstärkung der Ausgangssignale des Synchrongleichrichters abhängig von einer einschaltbaren Referenzimpedanz kalibrierbar ist.

Zur Ermittlung von Kapazitätswerten verwenden kapazitive Messsysteme häufig multifrequente Verfahren, die sich einer Ladungspumpe und eines Integrators bedienen. Innerhalb mehrerer Zyklen wird dabei eine leitende Fläche, die eine Kapazität mit der Erdung bildet, aufgeladen und die Ladungen in einem Integrationskondensator gespeichert. Nach Ende eines Messzyklusses wird dann die Spannung über dem Integrationskondensator ausgewertet.

Solche Verfahren haben den Nachteil, dass es damit nur schwer möglich ist, große Kapazitäten zu messen. Zudem gibt es Einschränkungen hinsichtlich der elektromagnetischen Verträglichkeit (EMV, EMC), wenn es um Störausstrahlung und Störunempfindlichkeit geht. Dieses gilt besonders bei großen Sensorflächen.

Unter diesen Aspekten haben sich monofrequente Verfahren als vorteilhaft erwiesen, bei denen Signale durch Synchrongleichrichter frequenzselektiv ausgewertet werden können.

Die vorliegende Erfindung betrifft ein kapazitives Messsystem zur Bestimmung von kleinen Kapazitätsänderungen auf großen Referenzkapazitäten, wobei von einem monofrequenten Messsignal Gebrauch gemacht wird. Solche Messsysteme können beispielsweise in Kraftfahrzeugen zur Handerkennung (Hands-On/Off-Detection) am Lenkrad, zur Sitzplatzbelegungserkennung, bei kapazitiven Pedalen, Belegungsmatten im Kofferraum sowie für Großflächenschalter im Allgemeinen eingesetzt werden.

Ein gattungsgemäßes kapazitives Messsystem ist aus der Veröffentlichung DE 11 2014 001 880 T5 bekannt. Die in diesem Dokument beschriebene kapazitive Erfassungsvorrichtung besitzt eine Antennenelektrode zum Aufbau eines elektrischen Wechselfelds als Reaktion auf eine in der Antennenelektrode eingespeiste Wechselspannung und eine Auswerteschaltung, die einen Transimpedanzverstärker aufweist, der durch Einspeisen eines Stroms in die Antennenelektrode die Wechselspannung gleich einer Referenzwechselspannung auf einem Referenzspannungsknoten hält und den Strom misst. Die Auswerteschaltung besitzt zudem einen Mikrocontroller und einen Multiplexer, der die Antennenelektrode abwechselnd zu einem Stromeingang des Transimpedanzverstärkers und zu dem Referenzwechselspannungsknoten schaltet. Der Mikrocontroller ist derart konfiguriert, dass er den Multiplexer steuert. Der Multiplexer und der Transimpedanzverstärker und ein mit dem Transimpedanzverstärker wirkverbundenes Tiefpassfilter bilden zusammen eine Synchrongleichrichteranordnung. Der Stromeingangsknoten des Transimpedanzverstärkers ist durch einen Schutzkondensator mit dem Referenzspannungsknoten wechselstromgekoppelt.

Nachteilig an diesem Messsystem ist, dass der Transimpedanzverstärker und der Multiplexer den Einsatz einer Vielzahl aktiver Bauelemente voraussetzt, die erheblich durch Umweltbedingungen, wie insbesondere die Umgebungstemperatur beeinflusst werden. Nachteilig ist auch, dass eine Kalibrierung nicht während der Verwendung des Messsystems erfolgen kann.

Eine Lenkradsensorik würde hier beispielsweise ein Loslassen des Lenkrads während eines Kalibriervorgangs erfordern.

Es stellte sich die Aufgabe, ein gattungsgemäßes Messsystem zu schaffen, das eine hohe Messempfindlichkeit bei gleichzeitiger geringer Empfindlichkeit gegen äußere Störeinflüsse, insbesondere Temperatureinflüsse, kombiniert und die vorgenannten Nachteile vermeidet.

Diese Aufgabe wird durch ein Messsystem gemäß Patentanspruch 1 gelöst. Dabei ist der Synchrongleichrichter durch einen MOS-Halbleiterschalter ausgeführt, dessen Source-Drain-Strecke einen durch das monofrequente Spannungssignal gesteuerten Shunt bildet, und das Messsystem ist dazu eingerichtet, beim Kalibriervorgang das durch einen Referenzspannungsteiler erzeugte Kalibriersignal über mindestens einen Kanal des analogen Multiplexers zu übertragen.

Die Ausbildung eines Synchrongleichrichters durch einen MOS-Halbleiterschalter, dessen Source-Drain-Strecke einen gesteuerten Shunt ausbildet ist besonders vorteilhaft, da hierbei kein temperaturempfindliches Bauteil in den Signalweg geschaltet ist. Durch Einschalten der Source-Drain-Strecke wird eine Halbwelle des Messsignals gegen Masse geschaltet und damit abgeschnitten. Die verbleibende Halbwelle bleibt durch den ausgeschalteten MOS-Halbleiterschalter dagegen vollkommen unbeeinflusst, so dass die Einweggleichrichtung auch keinerlei Beeinflussung durch die Umgebungstemperatur unterliegt.

Um eine hohe Empfindlichkeit bei der Signalauswertung zu erreichen, erfolgt die Auswertung anhand einer Vergleichsspannung, deren Höhe durch mindestens ein Kalibriersignal beeinflusst ist. Dieses mindestens eine Kalibriersignal wird mittels eines Referenzspannungsteilers erzeugt, der den gleichen Umgebungsbedingungen wie das übrige Messsystem ausgesetzt ist, so dass das Kalibriersignal diese Umgebungsbedingungen repräsentiert.

Besonders vorteilhaft ist, dass das mindestens eine Kalibriersignal über einen Kanal des analogen Multiplexers geleitet wird. Hierdurch nimmt das mindestens eine Kalibriersignal den gleichen Signalweg wie die Sensorsignale. Äußerst vorteilhaft ist es, zwei Referenzspannungsteiler vorzusehen, die jeweils ein Kalibriersignal für einen oberen und einen unteren Vergleichswert festlegen.

Besonders vorteilhaft ist es auch, dass für die Kalibrierung die zyklische Auswertung der Sensorsignale nicht unterbrochen werden muss, sondern die Kalibrierung als Teil des Auswertezyklus regelmäßig und quasi "zwischendurch" erfolgt.

Die Erfindung soll im Folgenden anhand der Zeichnung dargestellt und näher erläutert werden. Es zeigen
- Figur 1: ein erstes Blockschaltbild eines kapazitiven Messsystems,
- Figur 2: ein zweites Blockschaltbild des kapazitiven Messsystems,
- Figur 3: eine Skizze zum Aufbau der Lenkradsensorik.

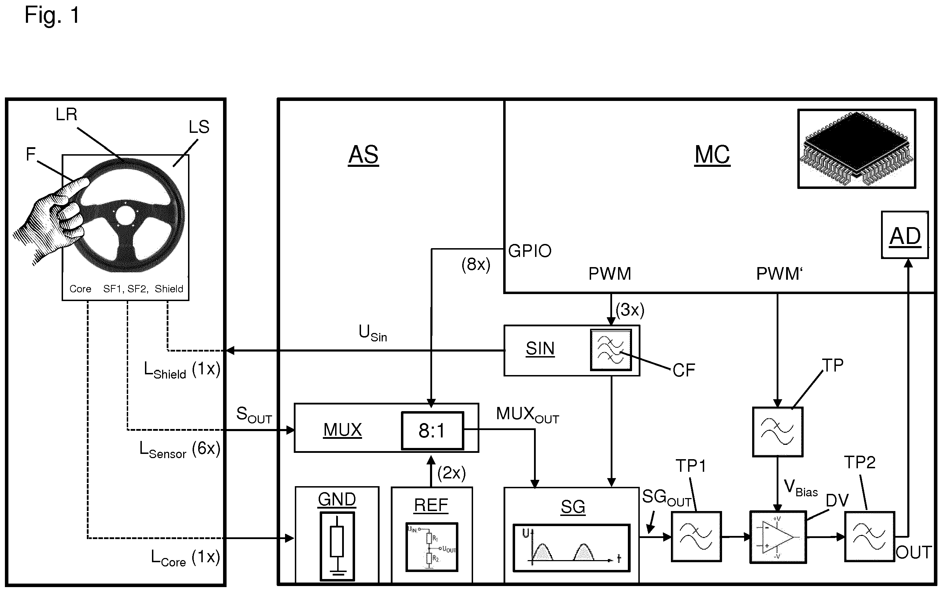

Die Figur 1 zeigt ein Blockschaltbild, welches die Funktionskomponenten eines erfindungsgemäßen kapazitiven Messsystems schematisch darstellt. Am Lenkrad LR eines Kraftfahrzeugs sind beispielsweise sechs, hier nicht im Detail dargestellte kapazitive Sensoren angeordnet, die zusammen eine Lenkradsensorik LS zur Erkennung einer Berührung des Lenkrads LR durch eine menschliche Hand oder speziell durch einen Finger F ausbilden.

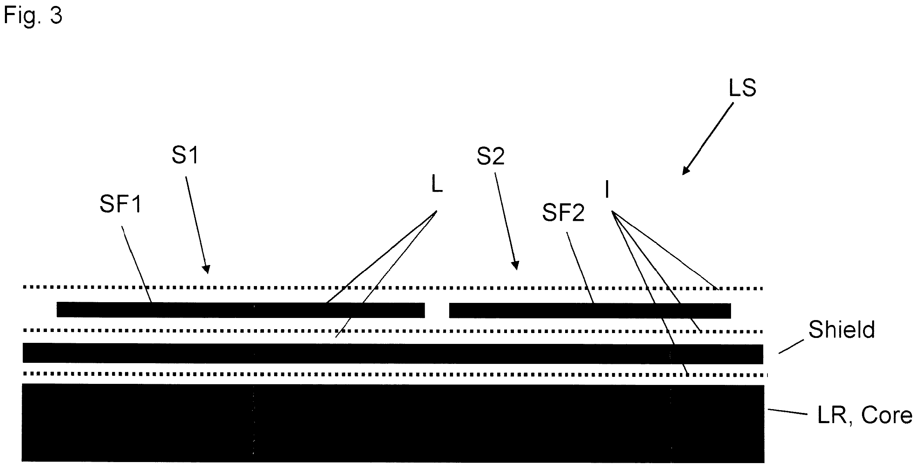

Das Aufbauprinzip der Lenkradsensorik LS ist in der Figur 3 skizzenhaft dargestellt. Die Lenkradsensorik LS besteht aus einer abwechselnd geschichteten Anordnung von Leitern L und Isolatoren I, die als Folien oder Metallgewebe auf oder um den Lenkradkranz, und gegebenenfalls auch auf oder um die Lenkradspeichen des Lenkrads LR herum, angeordnet sind. Die Leiter L bestehen vorzugsweise jeweils aus Kupferfolien oder Metallgewebe, die Isolatoren I aus Kunststofffolien. Der leitende Lenkradkern wird als Core bezeichnet. Darüber, durch einen Isolator I getrennt angeordnet, befindet sich ein Schirmleiter, der hier als Shield benannt ist. Die oberste Schicht von Leitern L wird durch mehrere nebeneinander angeordnete Sensorfolien SF1, SF2 gebildet, die im Gegensatz zu den anderen Leitern L nicht durchgängig sondern in mehreren getrennt nebeneinander liegenden Abschnitten am Lenkrad LR angeordnet sind und unterschiedliche Formen und Größen haben können. Die in der Figur 3 dargestellte Skizze zeigt speziell eine Anordnung von zwei kapazitiven Sensoren S1, S2. Durch Hinzufügen weitere Sensorfolien SF1, SF2 kann die Anzahl der Sensoren S1, S2 einfach auf einen vorgesehenen Wert erhöht werden.

Die Sensoren S1, S2 teilen sich die Schirmelektrode Shield, die dazu bestimmt ist, die Sensorfolien SF1, SF2 von dem geerdeten Metallkern des Lenkrads LR abzuschirmen. Die Schirmelektrode Shield ist dazu überlappend zu den Sensorfolien SF1, SF2 angeordnet.

Die in der Figur 1 dargestellte Lenkradsensorik LS ist rein beispielhaft mit sechs am Lenkrad LR angeordneten kapazitiven Sensoren ausgeführt, die in der Figur 1 nicht als Detail dargestellt sind. Von den Sensoren am Lenkrad LR führen insgesamt sechs Verbindungsleitungen Lsensor zu einer Auswerteschaltung AS. Die Verbindungsleitungen Lsensor sind mit den Sensorfolien SF1, SF2 verbunden. Weiterhin gibt es jeweils eine Verbindungsleitung L_{Shield} zur Schirmfolie Shield und eine Verbindungsleitung Lcore zum Mettalkern des Lenkrads. Die Anzahl der jeweils vorgesehenen Verbindungsleitungen ist in der Figur 1 jeweils durch eine in Klammern gesetzte Angabe (z. B. 6x) verdeutlicht.

In der Auswerteschaltung AS ist die Verbindungsleitung Lcore zum Lenkradkernüber einen Erdungswiderstand mit der Fahrzeugmasse GND verbunden. Die Schirmleitung L_{Shield} zur Schirmfolie Shield ist mit dem Ausgang einer Sinussignalerzeugungsvorrichtung SIN gekoppelt und dient zur Einkopplung eines monofrequenten Sinussignals U_{Sin} in die Lenkradsensorik LS.

Die sechs Sensorleitungen Lsensor sind in der Auswerteschaltung AS zu jeweils einem Eingang eines analogen Multiplexers MUX geführt. Zwei weitere Eingänge des hier als achtkanalig dargestellten Multiplexers MUX sind durch den Mittenanschluss jeweils eines von zwei Referenzspannungsteilern REF belegt.

Der Multiplexer MUX wird durch einen zur Auswerteschaltung AS gehörenden Mikrocontroller MC gesteuert. Eine besonders einfache und kostengünstige Ausführung des analogen Multiplexers MUX kann dadurch erzielt werden, dass dieser, aus einer, der vorgesehenen Kanalanzahl entsprechenden Anzahl von steuerbaren Analogschaltern besteht, die jeweils über einen programmierbaren Universalanschluss GPIO (general purpose input output) des Mikrocontrollers MC abwechselnd getaktet angesteuert werden.

Als Messsignal für die am Lenkrad LR angeordnete Lenkradsensorik LS wird aus EMV-Gründen ein monofrequentes Sinussignal Uₛᵢₙ eingesetzt, das eine Frequenz in der Größenordnung von 100 kHz aufweist. Zur Generierung des Sinussignals Uₛᵢₙ werden drei mittenzentrierte pulsweitenmodulierte Signale PWM verwendet, die vollständig durch die Hardware des Mikrocontrollers MC erzeugt werden. Das Sinussignal Uₛᵢₙ entsteht durch eine Formung dieser pulsweitenmodulierte Signale PWM durch ein Chebyshev-Filter CF. Die Signalerzeugung ist hier funktionell durch einen Schaltungsblock dargestellt, der als Sinussignalerzeugungsvorrichtung SIN bezeichnet ist.

Bei der Generierung eines erfassbaren Messsignals durch die Lenkradsensorik LS wird von der Dämpfung dieses monofrequenten Sinussignals Uₛᵢₙ Gebrauch gemacht. Das Sinussignal Uₛᵢₙ wird dazu über die Verbindungsleitung L_{Shield} auf die Schirmelektrode Shield (vgl. Figur 3) eingeprägt, die jeweils mit einer Sensorfolie SF1, SF2 einen kapazitiven Spannungsteiler ausbildet.

Am Ausgang des jeweiligen kapazitiven Spannungsteilers, also an den Sensorfolien SF1, SF2 fällt jeweils ein gedämpftes Sinussignal mit gleicher Frequenz und Phase, jedoch mit kleinere Amplitude ab. Die Kapazitätswerte der Sensoren S1, S2 werden durch die Anwesenheit einer Hand oder eines Fingers beeinflusst, wodurch sich die Amplituden der an den Sensorfolien SF1, SF2 anliegenden Sensorsignale Sₒᵤₜ verändern.

Die Sensorsignale Sₒᵤₜ liegen gleichzeitig an den Eingängen des Multiplexers MUX an und werden, gesteuert durch den Mikrocontroller MC, abwechselnd nacheinander an dessen Ausgang übertragen.

Das jeweils am Ausgang des Multiplexers MUX vorliegende Signal MUX_{OUT} wird an den Eingang eines Synchrongleichrichters SG weitergeleitet, dem das monofrequente Sinussignals Uₛᵢₙ als Referenzsignal zugeführt wird. Der Synchrongleichrichter SG richtet frequenzselektiv Ausgangsignale MUX_{OUT} des Multiplexers MUX gleich, welche die gleiche Frequenz wie das in die Schirmleitung L_{Shield} eingekoppelten monofrequente Sinussignal U_{Sin} besitzen. Hierdurch werden Störsignale, die andere Frequenzen aufweisen, wirkungsvoll unterdrückt.

Das Ausgangssignal SGₒᵤₜ des Synchrongleichrichters SG wird durch einen Differenzverstärker DV verstärkt, dem zur Anpassung der Empfindlichkeit eine Vergleichsspannung V_{Bias} zugeführt wird. Das Ausgangssignal OUT des Differenzverstärkers DV wird über eine weitere Tiefpassschaltung TP2 gefiltert und durch einen zum Mikrocontroller MC gehörenden Analogdigitalwandler AD digitalisiert, dann durch den Mikrocontroller MC ausgewertet und vom Mikrocontroller MC gegebenenfalls zur Steuerung von Funktionen verwendet, die den erkannten Signalen zugeordnet sind.

Die jeweils optimale Vergleichsspannung V_{Bias} zur Anpassung der Empfindlichkeit wird durch den Mikrocontroller MC berechnet. Um diese dem Differenzverstärker DV vorzugeben, beeinflusst der Mikrocontroller MC das Tastverhältnis eines pulsweitenmodulierten Signals PWM', welches durch eine Tiefpassschaltung TP zur Vergleichsspannung V_{Bias} geglättet wird.

Das Vergleichsspannung V_{Bias} hängt dabei von mindestens einem Referenzspannungssignal ab, welches von mindestens einem Referenzspannungsteiler REF erzeugt. Das Referenzspannungssignal ist dabei durch Umwelteinflüssen beeinflusst, denen der mindestens eine Referenzspannungsteiler REF ausgesetzt ist. Sind mehrere, wie etwa in diesem Ausführungsbeispiel zwei Referenzspannungsteiler REF vorgesehen, so können diese auch mehrere Parameter, etwa einen Höchst- und einem Mindestwert, vorgeben.

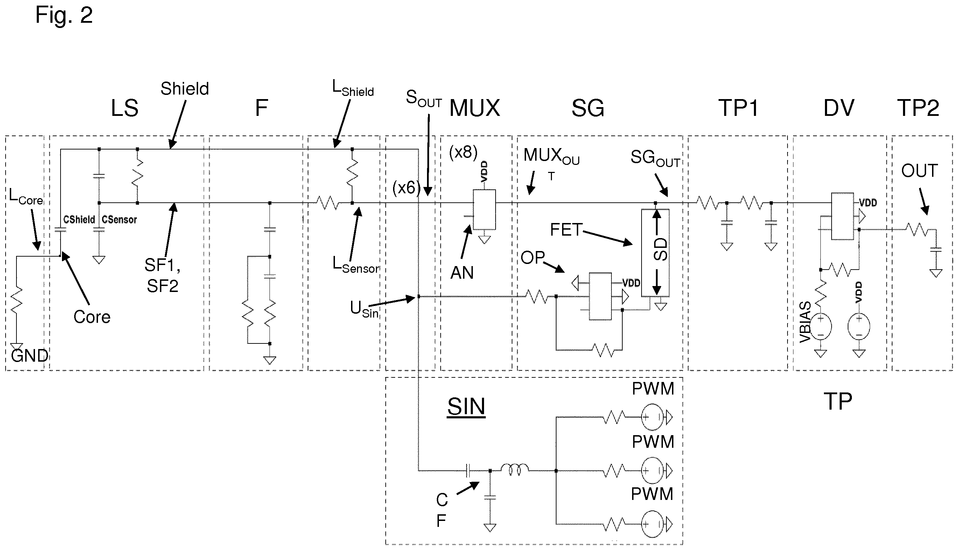

Das an jeweils dem Mittenabgriff eines Referenzspannungsteilers REF vorliegende Referenzspannungssignal wird jeweils einem Eingang des Multiplexers MUX zugeführt, so dass das Referenzspannungssignal den gleichen Signalweg wie die Sensorsignale Sₒᵤₜ durchlaufen und am Ende ebenfalls durch den Analogdigitalwandler AD digitalisiert und durch den Mikrocontroller MC ausgewertet werden. Der Mikrocontroller MC kann so durch Anpassung des ausgegebenen pulsweitenmodulierten Signals PWM' die Vergleichsspannung V_{Bias} an die aktuell vorliegenden Referenzspannungswerte anpassen, ohne dass dadurch die Erfassung der Sensorsignale am Lenkrad LR unterbrochen werden müssen. Vorteilhafte Einzelheiten der Auswerteschaltung sollen durch die Figur 2 verdeutlicht werden, welche einige besondere einzelne Schaltungsdetails anhand der Anordnung elektronischer Bauteile veranschaulicht. Dabei ist die Auswerteschaltung hier noch immer vereinfacht und schematisiert dargestellt. Insbesondere wurde aus Gründen eine bessere Übersichtlichkeit in der Figur 2 auf die Darstellung des die Steuerung ausführenden Mikrocontrollers verzichtet. Verschiedene Funktionsblöcke sind übereinstimmend mit den entsprechenden Funktionsblöcken in der Figur 1 bezeichnet. Da die grundsätzliche Funktionsweise bereits anhand der Figur 1 erläutert wurde, soll sich die Erläuterung der Figur 2 auf einige Besonderheiten beschränken.

Der Schaltungsblock skizziert die durch die Figur 3 dargestellte kapazitive Lenkradsensorik LS anhand eines Ersatzschaltbildes, welche insbesondere zeigt, dass die Lenkradsensorik LS einen bzw. mehrere (hier ist nur eine von mehreren Sensorleitungen Lsensor dargestellt) kapazitiven Spannungsteiler ausbildet. Auch der menschliche Finger F ist als ein Ersatzschaltbild aus kapazitiven und ohmschen Komponenten dargestellt, die elektrisch zwischen einer der Sensorfolien SF1, SF2 und der Fahrzeugmasse wirken.

Die Sensorleitung L_{Sensor} führt zu Eingang eines Analogschalters AN des Multiplexers MUX. Entsprechend der hier beispielhaft achtkanaligen Ausführung des Multiplexers MUX enthält dieser acht einzelne Analogschalter AN, von denen hier nur einer abgebildet ist. Die Eingänge von sechs dieser acht Analogschalter AN sind mit Sensorleitungen Lsensor belegt, zwei weitere Eingänge mit den Mittenanschlüssen von jeweils einem Referenzspannungsteiler REF (nur in der Figur 1 dargestellt) verbunden.

Um geerdete Körper, wie etwa Hände oder Finger am Lenkrad, mit guter Empfindlichkeit in der Nähe eines Sensors detektieren zu können, wird die Schaltung bezüglich der Umweltbedingungen (Temperatur, Feuchtigkeit, Alterung, usw.) kalibriert. Hierzu dienen die nur in der Figur 1 dargestellten Referenzspannungsteiler REF mit bekannten Impedanzen. Wie die Figur 1 andeutet, können die Referenzspannungsteiler REF einfach als ohmsche Spannungsteiler ausgebildet sein, deren Außenanschlüsse jeweils mit einem festen Potential, etwa mit den Polen der Versorgungsspannung der Auswerteschaltung AS verbunden sind.

Die Analogschalter AN des Multiplexers MUX werden abwechselnd nacheinander durch den Mikrocontroller (in der Figur 2 nicht dargestellt) eingeschaltet, so dass dessen jeweiliges Eingangssignal auf den Ausgang des Multiplexers MUX und damit auch zum Eingang des Synchrongleichrichters SG gelangt.

Um ein Gleichspannungssignal zu erhalten, wird das Ausgangssignal MUX_{OUT} des Multiplexers MUX über einen geschalteten Shunt in Form der Source-Drain-Strecke SD eines MOSFET-Halbleiterschalters FET phasenempfindlich halbwellengleichgerichtet und anschließend durch eine Tiefpassschaltung TP1 gefiltert. Das Gate G des MOSFET-Halbleiterschalters FET wird hierbei durch das monofrequente Sinussignal Uₛᵢₙ gesteuert. Der dem Gate G vorgeschaltete Operationsverstärker OP dient zur Pegelanpassung.

In dem Differenzverstärker DV wird die Differenz des gefilterten Messsignals zu der Vergleichsspannung V_{Bias} verstärkt. Über die Differenz der Vergleichsspannung V_{Bias} zum Messsignal wird die Empfindlichkeit der Schaltung kalibriert. Die Anpassung der Empfindlichkeit des Differenzverstärkers DV ermöglicht es, zur Bestimmung eines Nutzsignals den gesamten Eingangsspannungsbereich des Analogdigitalwandlers AD auszunutzen.

### Bezugszeichen

- AD: Analogdigitalwandler
- AN: Analogschalter
- AS: Auswerteschaltung
- Core: Kernelektrode
- CF: Chebyshev-Filter
- DV: Differenzverstärker
- FET: MOSFET-Halbleiterschalter
- G: Gate
- GND: Fahrzeugmasse
- GPIOS: Universalanschlüsse (General Purpose Input-Output)
- I: Isolatoren, Isolation(sfolie)
- L: Leiter
- LR: Lenkrad
- LS: Lenkradsensorik (kapazitive Sensoren)
- Lcore: Verbindungsleitung (Kernleitung)
- Lsensor: Verbindungsleitungen (Sensorleitung(en))
- L_{Shield}: Verbindungsleitung (Schirmleitung (Shield-Elektrode))
- MC: Mikrocontroller
- MUX: (analoger) Multiplexer
- MUX_{OUT}: Ausgangssignale (des Multiplexers)
- OP: Operationsverstärker
- PWM, PWM': Pulsweitenmoduliertes Signal
- REF: Referenzspannungsteiler
- S1, S2: kapazitive Sensoren
- SD: Source-Drain-Strecke
- SF1, SF2: Sensorfolien
- SG: Synchrongleichrichter
- SGₒᵤₜ: Ausgangssignale (des Synchrongleichrichters)
- SIN: Sinussignalerzeugungsvorrichtung
- Shield: Schirmelektrode
- Sₒᵤₜ: Ausgangssignale (der Sensoren), Sensorsignale
- TP, TP1, TP2: Tiefpassschaltung
- Uₛᵢₙ: monofrequentes Sinussignal
- V_{bias}: Vergleichsspannung (Vergleichsspannung)
- OUT: Ausgangssignal (des Differenzverstärkers)

## Patentansprüche

1. Kapazitives Messsystem, welches mehrere kapazitive Sensoren (S1, S2) und eine Auswerteschaltung (AS) aufweist,
wobei die kapazitiven Sensoren (S1, S2) mit einem monofrequenten Spannungssignal (Uₛᵢₙ) beaufschlagt werden,
wobei die Ausgangssignale (Sₒᵤₜ) der kapazitiven Sensoren (S1, S2) über einen mehrkanaligen analogen Multiplexer (MUX) alternierend mit einem Synchrongleichrichter (SG) verbunden werden,
wobie
der Synchrongleichrichter (SG) durch einen MOS-Halbleiterschalter (FET) ausgeführt ist, dessen Source-Drain-Strecke (SD) einen durch das monofrequente Spannungssignal (Uₛᵢₙ) gesteuerten Shunt bildet,
wobei
mindestens ein Kanal des analogen Multiplexers (MUX) zur Übertragung eines durch einen Referenzspannungsteiler (REF) erzeugten Kalibriersignals eingerichtet ist,
wobei das Messsystem dazu eingerichtet ist, die Signalverstärkung der Ausgangssignale (SGout) des Synchrongleichrichters (SG) abhängig vom Kalibriersignal zu kalibrieren und dabei das Kalibriersignal über den Multiplexer übertragen wird.

2. Kapazitives Messsystem nach Anspruch 1, **dadurch gekennzeichnet, dass** zwei Kanäle des analogen Multiplexers (MUX) zur Übertragung eines durch jeweils den Referenzspannungsteiler (REF) erzeugten Kalibriersignals für eine Ober- und Untergrenze eingerichtet sind.

3. Kapazitives Messsystem nach Anspruch 1, welches so eingerichtet ist, dass das monofrequente Signal (Uₛᵢₙ) eine Sinusspannung ist, die mittels eines Chebyshev-Filters (CF) sowie durch drei mittenzentrierte pulsweitenmodulierte Spannungen (PWM) erzeugt werden, die durch einen Mikrocontroller (MC) generiert werden.

4. Kapazitives Messsystem nach Anspruch 1, **dadurch gekennzeichnet, dass** das kapazitive Messsystem zur Handerkennung am Lenkrad (LR) eines Kraftfahrzeuges eingerichtet ist.

## Claims

1. Capacitive measuring system which has a plurality of capacitive sensors (S1, S2) and an evaluation circuit (AS),
wherein a monofrequency voltage signal (Uₛᵢₙ) is applied to the capacitive sensors (S1, S2),
wherein the output signals (Sₒᵤₜ) of the capacitive sensors (S1, S2) are alternately connected to a synchronous rectifier (SG) via a multi-channel analogue multiplexer (MUX),
wherein the synchronous rectifier (SG) is implemented by a MOS semiconductor switch (FET) whose source-drain path (SD) forms a shunt controlled by the monofrequency voltage signal (Uₛᵢₙ),
wherein at least one channel of the analog multiplexer (MUX) is provided for the transmission of a calibration signal generated by a reference voltage divider (REF),
wherein the measuring system is arranged to calibrate the signal amplification of the output signals (SGₒᵤₜ) of the synchronous rectifier (SG) in dependence on the calibration signal, and wherein the calibration signal is transmitted via the multiplexer.

2. Capacitive measuring system according to claim 1, **characterised in that** two channels of the analogue multiplexer (MUX) are set up for the transmission of a calibration signal generated by the reference voltage divider (REF) for an upper and lower limit in each case.

3. Capacitive measurement system according to claim 1, which is arranged such that the monofrequency signal (Uₛᵢₙ) is a sinusoidal voltage generated by means of a Chebyshev filter (CF) and by three centre-centred pulse width modulated (PWM) voltages generated by a microcontroller (MC).

4. Capacitive measuring system according to claim 1, **characterised in that** the capacitive measuring system is set up for hand detection on the steering wheel (LR) of a motor vehicle.

## Revendications

1. Système de mesure capacitif, qui comporte plusieurs capteurs capacitifs (S1, S2) et un circuit d'évaluation (AS),
les capteurs capacitifs (S1, S2) étant alimentés par un signal de tension monofréquence (Uₛᵢₙ),
les signaux de sortie (Sₒᵤₜ) des capteurs capacitifs (S1, S2) étant reliés alternativement à un redresseur synchrone (SG) par l'intermédiaire d'un multiplexeur analogique à plusieurs canaux (MUX), le redresseur synchrone (SG) étant réalisé par un commutateur à semi-conducteur MOS (FET) dont le trajet source-drain (SD) forme un shunt commandé par le signal de tension monofréquence (Uₛᵢₙ),
au moins un canal du multiplexeur analogique (MUX) étant prévu pour la transmission d'un signal de calibrage généré par un diviseur de tension de référence (REF), le système de mesure étant conçu pour calibrer l'amplification
des signaux de sortie (SGₒᵤₜ) du redresseur synchrone (SG) en fonction du signal de calibrage, le signal de calibrage étant alors transmis par le biais du multiplexeur.

2. Système de mesure capacitif selon la revendication 1, **caractérisé en ce que** deux canaux du multiplexeur analogique (MUX) sont aménagés pour transmettre un signal d'étalonnage généré par le diviseur de tension de référence (REF) pour une limite supérieure et une limite inférieure.

3. Système de mesure capacitif selon la revendication 1, qui est agencé de telle sorte que le signal monofréquence (Uₛᵢₙ) est une tension sinusoïdale générée au moyen d'un filtre de Chebyshev (CF) et de trois tensions à modulation de largeur d'impulsion (PWM) centrées sur le centre, qui sont générées par un microcontrôleur (MC).

4. Système de mesure capacitif selon la revendication 1, **caractérisé en ce que** le système de mesure capacitif est conçu pour la détection de la main sur le volant (LR) d'un véhicule automobile.
